# EUROPEAN PATENT SPECIFICATION

(11) **EP 2 681 847 B1**
(45) Date of publication and mention of the grant of the patent: **09.09.2015**
(21) Application number: 12722707.2
(22) Date of filing: 11.05.2012
(51) Int. Cl.: H04B 1/036, H01L 23/467

(54) **COOLING SYSTEM AND METHOD FOR COOLING RADIO UNIT**
KÜHLSYSTEM UND VERFAHREN ZUR KÜHLUNG EINER FUNKEINHEIT
SYSTÈME ET PROCÉDÉ DE REFROIDISSEMENT PERMETTANT DE REFROIDIR UN BLOC RADIO

(43) Date of publication of application: 08.01.2014
(73) Proprietor: Huawei Technologies Co., Ltd., Longgang District Shenzhen, Guangdong 518129 (CN)
(72) Inventor: SHI, Jian, 16440 Kista (SE); HAWORTH, Stephan, Berkshire RG40 4RA (GB); ZHANG, Yi, 16440 Kista (SE)
(74) Representative: Thun, Clemens
(86) International application number: PCT/EP2012/058812
(87) International publication number: WO 2013/167203

(56) References cited:
- GB-A- 2 296 132
- US-A- 5 563 768
- US-A1- 2005 006 063
- US-B2- 8 136 577

## Description

### TECHNICAL FIELD

The present invention relates to a cooling system for cooling at least one heat generating radio unit in an active antenna system unit. The invention also relates to a method for cooling at least one heat generating radio unit in an active antenna system unit.

### BACKGROUND OF THE INVENTION

As the efficiency of e.g. power amplifiers and other components in radio units is not 100%, radio units emit heat, i.e. the radio unit comprises heat generating components whereby the radio unit needs to be cooled. The radio unit may be cooled using a heat sink by thermally connecting the radio unit against the heat sink base in order to be able to transfer heat from the radio unit to the heat sink and from there to the ambient air. The heat sink is further generally arranged with cooling fins in order to improve the cooling of the radio unit.

If more cooling power is needed, it is possible to arrange forced cooling of the heat sink, i.e. to arrange a fan that forces a flow of air across the surfaces of the cooling fins of the heat sink thereby replacing air heated by the heat from the cooling fins with cooler ambient air from the outside of the heat sink, thus improving the cooling of the heat sink.

In order to reduce Radio Frequency loss and to save energy without affecting radio performance, a telecom radio unit, e.g. a radio transceiver, is preferably arranged as close as possible to the antenna. This also enables reduction of radio unit volume, weight and cost. Thus, a radio unit is preferably installed or mounted directly on the antenna (i.e. semi-integrated installation) or integrated with the antenna (i.e. integrated installation) on top of a tower or at a similar high mounting position in an active antenna system unit. The active antenna system unit is generally arranged with one end of its longitudinal extension more or less below the other, i.e. arranged more or less in a vertical position, depending on the preferred positioning of the antenna or antennas of the active antenna system unit. The heat sinks of the radio units are arranged with cooling fins extending along the longitudinal extension of the active antenna system unit in order to improve the natural cooling. If more than one radio unit is arranged together with an antenna in an active antenna system unit, the radio units are arranged displaced along the longitudinal extension of the active antenna system unit, i.e. along the longitudinal extension of the antenna or antennas in order to protrude as little as possible outside the antenna face, thereby minimizing the transversal dimensions of the active antenna system unit. For example, US 5,563,768 refers to a method of cooling a heat source including the steps of positioning a thermally conductive base in contact with the heat source, the base having a plurality of fins which define a plurality of channels, generating an initial flow of fluid, positioning a baffle in the path of the initial flow of fluid so as to create a primary flow of fluid and a secondary flow of fluid, directing the primary flow of fluid against the plurality of fins so as to form a quantity of spent fluid which is advanced into the channels, directing the secondary flow of fluid into the plurality of channels so as to force the quantity of spent fluid out of the plurality of channels, and repositioning the baffle from a first position to a second position to change the magnitude of the primary flow of fluid. An apparatus for cooling a heat source which splits an initial flow of fluid into a primary flow of fluid and a secondary flow of fluid is also disclosed. Further, US 8,136,577 B2 refers to a heat dissipation device comprising at least one inlet plenum, at least one outlet plenum and chambers, in which the chambers communicate directly with the inlet plenum and with the outlet plenum. Also provided is a heat dissipation device comprising at least two inlet plenums, at least two outlet plenums and at least two chambers, the first chamber communicating directly with a first inlet plenum and a first outlet plenum, the second chamber communicating directly with a second inlet plenum and a second outlet plenum. Also provided are methods of dissipating heat, comprising passing fluid across and/or through such devices. Also provided are radar antennas comprising radar electronic components mounted on such devices.

Due to the often limited base area of a heat generating component in a radio unit and the desire to place more and more functionality on a defined base area of a component, more and more powerful components are developed, e.g. higher integration components. This increase in component capacity leads to that more power can be fed to components per component base area than before which in turn results in that the components emit more heat per base area than before when in maximum use e.g. during peak load in telecom systems, i.e. the maximum heat load of components is increasing as they may be fed with more power per square centimetre (W/cm2) base area. This is also the case for components for radio units.

As mentioned above, increased cooling power for a radio unit heat sink is traditionally achieved by increasing the cooling fin area, e.g. by arranging higher cooling fins, or by arranging a forced cooling. The drawback with these solutions is that the cooling fin dimensions cannot be increased indefinitely due to manufacturing difficulties and cost, and that the mounting of cooling fans affect the natural cooling when the fans are not in operation.

### SUMMARY OF THE INVENTION

The object of the present invention is to provide an improved cooling system for cooling at least one heat generating radio unit in an active antenna system unit and an improved method for cooling at least one heat generating radio unit in an active antenna system unit.

The object is achieved by arranging a cooling system for cooling at least one heat generating radio unit in an active antenna system unit, the cooling system comprising at least one fan and an air duct, where each heat generating radio unit to be cooled by the cooling system is arranged connected to a heat sink unit comprising cooling fins, the heat sink unit being arranged to transfer heat between the radio unit and the ambient air, where the at least one fan is arranged to generate a primary air flow of ambient air in the air duct between at least one air duct inlet and at least one air duct outlet, where the air duct is arranged to extend in the longitudinal direction of the active antenna system unit along each of the said heat sink units and to border on each of the said heat sink units, thus arranging the primary air flow generated in the air duct to flow substantially in the longitudinal direction of the active antenna system unit, where the cooling fins to be cooled by the secondary air flow are arranged oriented at an angle being not zero degrees with respect to the longitudinal direction of the active antenna system unit, wherein the at least one air duct outlet is arranged to direct a air flow of ambient air over the number of cooling fins of each of said heat sink units, thus generating a secondary air flow of ambient air over the number of cooling fins of each of said heat sink units, wherein the at least one air duct outlet is arranged along a longitudinal side of the active antenna system unit, wherein a gap size of the air duct outlet is arranged with a narrowing gap size along the longitudinal direction of the active antenna system unit.

The object is further achieved by a method for manufacturing a cooling system for cooling at least one heat generating radio unit in an active antenna system unit, the cooling system comprising at least one fan and an air duct, the method comprising the steps of: connecting each heat generating radio unit to be cooled by the cooling system to a heat sink unit comprising cooling fins, arranging the heat sink unit to transfer heat between the radio unit and the ambient air, arranging the at least one fan to generate a primary air flow of ambient air in the air duct between at least one air duct inlet and at least one air duct outlet, arranging the air duct to extend in the longitudinal direction of the active antenna system unit along each of the said heat sink units and to border on each of the said heat sink units, thus arranging the primary air flow generated in the air duct to flow substantially in the longitudinal direction of the active antenna system unit and arranging the cooling fins to be oriented at an angle being not zero degrees with respect to the longitudinal direction of the active antenna system unit, further comprising the step of arranging the at least one air duct outlet to direct a air flow of ambient air over the number of cooling fins of each of the heat sink units, thus generating a secondary air flow of ambient air over the number of cooling fins of each of said heat sink units, wherein the at least one air duct outlet is arranged along a longitudinal side of the active antenna system unit, wherein a gap size of the air duct outlet with a narrowing gap size along the longitudinal direction of the active antenna system unit is arranged.

By arranging a cooling system for cooling at least one heat generating radio unit in an active antenna system unit, where each heat generating radio unit to be cooled by the cooling system is arranged connected to a heat sink unit comprising cooling fins and where at least one fan is arranged to generate a primary air flow of ambient air in an air duct between at least one air duct inlet and at least one air duct outlet, where the air duct is arranged to extend in the longitudinal direction of the active antenna system unit along each of the said heat sink units and to border on each of the said heat sink units, where the primary air flow generated in the air duct is arranged to flow substantially in the longitudinal direction of the active antenna system unit and is further arranged to generate a secondary air flow of ambient air over a number of cooling fins of each of the said heat sink units, and where the cooling fins to be cooled by the secondary air flow are arranged oriented at an angle with respect to the longitudinal direction of the active antenna system unit, the longitudinal extension of the cooling fins to be cooled by the ambient air flow can be reduced whereby the temperature of the ambient air flow at the downstream end of the respective cooling fin can be reduced, thus increasing the cooling power at this position of the respective heat sink which is especially advantageous when using radio units with heat sinks having large dimensions in the longitudinal direction of the active antenna system unit. A further advantage is that the air duct and the fan does not affect the natural cooling when the at least one fan is shut off in situations where forced cooling is not needed, e.g. when the ambient temperature is so low that natural cooling is enough. A further advantage is that the at least one fan and air duct do not increase the volume of the active antenna system unit significantly.

By arranging a method for cooling at least one heat generating radio unit in an active antenna system unit using a cooling system comprising the steps of: connecting each heat generating radio unit to be cooled by the cooling system to a heat sink unit comprising cooling fins, arranging the heat sink unit to transfer heat between the radio unit and the ambient air, arranging at least one fan to generate a primary air flow of ambient air in an air duct between at least one air duct inlet and at least one air duct outlet, arranging the air duct to extend in the longitudinal direction of the active antenna system unit along each of the said heat sink units and to border on each of the said heat sink units, arranging the primary air flow generated in the air duct to flow substantially in the longitudinal direction of the active antenna system unit and further arranging the primary air flow to generate a secondary air flow of ambient air over a number of cooling fins of each of the said heat sink units, and arranging the cooling fins to be cooled by the secondary air flow to be oriented at an angle with respect to the longitudinal direction of the active antenna system unit, the longitudinal extension of the cooling fins to be cooled by the ambient air flow can be reduced whereby the temperature of the ambient air flow at the downstream end of the respective cooling fin can be reduced, thus increasing the cooling power at this position of the respective heat sink which is especially advantageous when using radio units with heat sinks having large dimensions in the longitudinal direction of the active antenna system unit. A further advantage is that the air duct and the fan does not affect the natural cooling when the at least one fan is shut off in situations where forced cooling is not needed, e.g. when the ambient temperature is so low that natural cooling is enough. A further advantage is that the at least one fan and air duct do not increase the volume of the active antenna system unit significantly.

According to one embodiment of the invention, a cover is arranged at the air duct to direct the air flow leaving the air duct outlet towards the surface of the heat sink unit.

According to one example not forming part of the invention, the at least one air duct inlet is arranged to suck a secondary air flow of ambient air over a number of cooling fins of each of the said heat sink units.

According to one example not forming part of the invention, the at least one air duct inlet is arranged along a longitudinal side of the active antenna system unit.

According to one example not forming part of the invention, the gap size of the air duct inlet is arranged with varying dimensions along the longitudinal direction of the active antenna system unit.

According to one embodiment of the invention, the angle between a cooling fin and the longitudinal direction of the active antenna system unit is arranged to vary along the extension of the cooling fin.

According to one embodiment of the invention, a cooling fin is arranged with varying dimensions along the longitudinal extension of the cooling fin.

According to one embodiment of the invention, a cooling fin is arranged wave formed or with curved shape along the longitudinal extension of the cooling fin.

According to one embodiment of the invention, the at least one fan is a centrifugal fan.

According to one example not forming part of the invention n, the method for cooling a heat generating unit can comprise the step of arranging the at least one air duct inlet to suck a secondary air flow of ambient air over a number of cooling fins of each of the heat sink units.

Further advantages of the invention will be apparent from the following detailed description.

### BRIEF DESCRIPTION OF THE DRAWINGS

The appended drawings are intended to clarify and explain different embodiments of the present invention in which:
Fig. 1 shows a schematic view of a cooling system according to a first embodiment of the invention for cooling at least one heat generating radio unit in an active antenna system unit,
Fig. 2 shows another schematic view of the cooling system according to figure 1,
Fig. 3 shows a schematic cross-section of an air duct according to one embodiment of the invention,
Fig. 4 shows another schematic cross-section of an air duct according to one embodiment of the invention,
Fig. 5 shows a schematic view of a cooling system according to a second embodiment of the invention,
Fig. 6 shows a schematic view of a cooling system according to a third embodiment of the invention, and
Fig. 7 shows a schematic view of a cooling system according to a fourth embodiment of the invention.

### DETAILED DESCRIPTION OF THE INVENTION

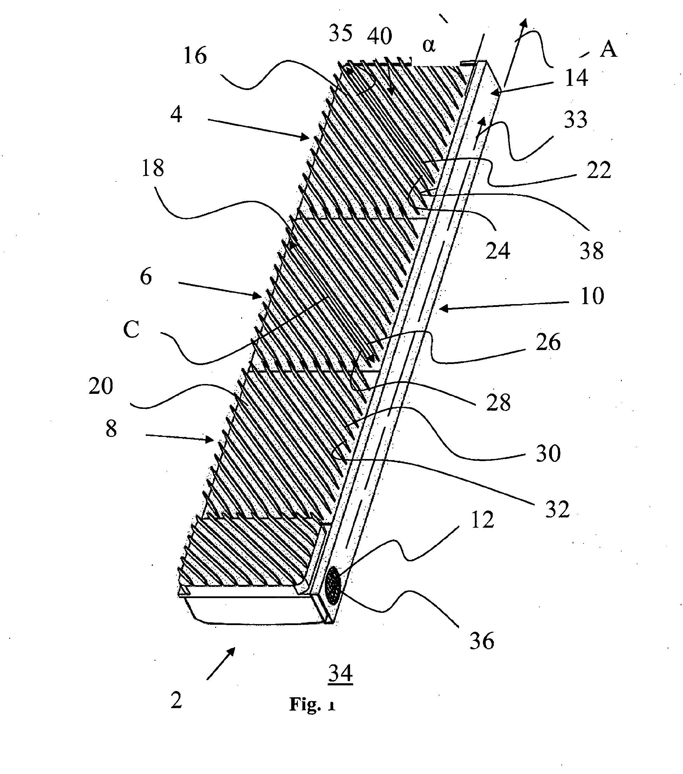

Fig. 1 shows a schematic view of a cooling system 2 according to a first embodiment of the invention for cooling at least one heat generating radio unit 4, 6, 8 in an active antenna system unit 10, the cooling system 2 comprising at least one fan 12 and an air duct 14, where each heat generating radio unit 4, 6, 8 to be cooled by the cooling system 2 is arranged connected to a heat sink unit 16, 18, 20 comprising cooling fins 22, 24, 26, 28, 30, 32, the heat sink unit 16, 18, 20 being arranged to transfer heat between the radio unit 4, 6, 8 and the ambient air 34, where the at least one fan 12 is arranged to generate a primary air flow 33 of ambient air 34 in the air duct 14 between at least one air duct inlet 36 and at least one air duct outlet 38, where the air duct 14 is arranged to extend in the longitudinal direction A of the active antenna system unit 10 along each of the said heat sink units 16, 18, 20 and to border on each of the said heat sink units 16, 18, 20 where the primary air flow 33 generated in the air duct 14 is arranged to flow substantially in the longitudinal direction A of the active antenna system unit 10 and is further arranged to generate a secondary air flow 35 of ambient air 34 over a number of cooling fins 22, 24, 26, 28, 30, 32 of each of the said heat sink units 16, 18, 20, where the cooling fins 22, 24, 26, 28, 30, 32 are arranged oriented at an angle α with respect to the longitudinal direction A of the active antenna system unit 10.

By arranging the cooling fins 22, 24, 26, 28, 30, 32 to be cooled by the secondary air flow 35 to be oriented at an angle α with respect to the longitudinal direction A of the active antenna system unit 10, the longitudinal extension C of the cooling fins 22, 24, 26, 28, 30, 32 to be cooled by the ambient air flow can be reduced when comparing with traditional designs, whereby the temperature of the ambient air flow at the downstream end of the respective cooling fin 22, 24, 26, 28, 30, 32 can be reduced, thus increasing the cooling power at this position of the respective heat sink unit 16, 18, 20 which is especially advantageous when using radio units 4, 6, 8 with heat sinks units 16, 18, 20 having large dimensions in the longitudinal direction A of the active antenna system unit 10. A further advantage is that the air duct 14 and the at least one fan 12 do not affect the natural cooling when the at least one fan 12 is shut off in situations where forced cooling is not needed, e.g. when the ambient temperature is so low that natural cooling is enough.

According to this embodiment, the at least one fan 12 is arranged to generate a primary air flow 33 of ambient air 34 in the air duct 14 between at least one air duct inlet 36 and at least one air duct outlet 38 by introducing ambient air 34 into the air duct 14 from at least one air duct inlet 36 and where the air duct outlet 38 is arranged to direct a flow of ambient air 34 over a number of cooling fins 22, 24, 26, 28, 30, 32 of each of the said heat sink units 16, 18, 20, where the cooling fins 22, 24, 26, 28, 30, 32 are arranged oriented at an angle with respect to the longitudinal direction A of the active antenna system unit 10.

The active antenna system unit 10 comprises at least one heat generating radio unit 4, 6, 8 and at least one antenna 40 both arranged along the longitudinal direction A of the active antenna system unit 10, and further comprises a cooling system for cooling at least one heat generating radio unit 4, 6, 8, where the respective radio unit 4, 6, 8 is installed or mounted directly on the antenna (i.e. semi-integrated) or integrated with the antenna (i.e. integrated).

The at least one fan 12 is preferably a centrifugal fan arranged at one end of the air duct 14 arranged at one longitudinal side of the active antenna system unit 10.

The at least one fan 12 and the air duct 14 can be arranged as two individual parts that are assembled together on site, or be arranged as an integrated unit.

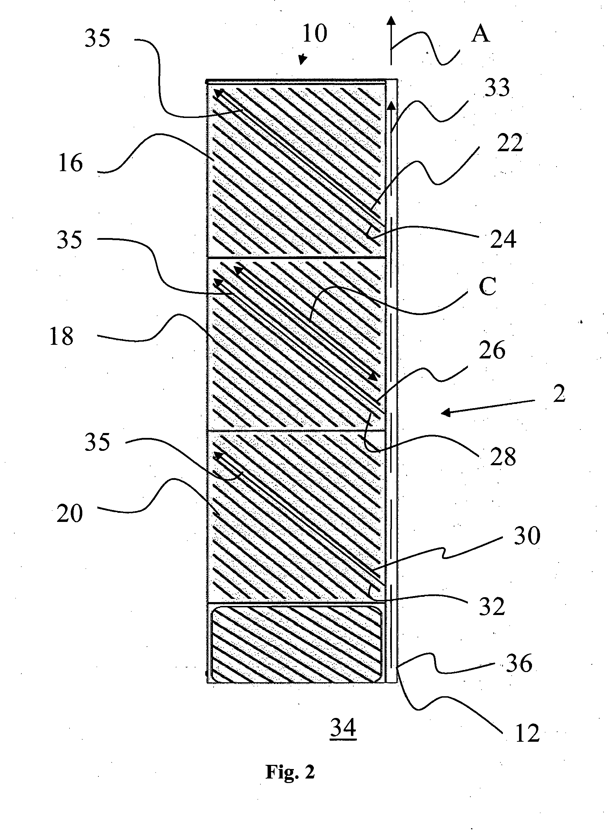

Fig. 2 shows another schematic view of the cooling system 2 according to figure 1, where the direction of flow of ambient air 34 is schematically shown in the figure. As shown in the figure, the ambient air 34 is introduced into the air duct 14 at at least one air duct inlet 36, flows 33 through the air duct 14 along the longitudinal direction A of the active antenna system unit 10, and leaves the air duct 14 at least one air duct outlet 38 directing a flow 35 of ambient air 34 over a number of cooling fins 22, 24, 26, 28, 30, 32 of each of the said heat sink units 16, 18, 20, where the cooling fins 22, 24, 26, 28, 30, 32 are arranged oriented at an angle α with respect to the longitudinal direction A of the active antenna system unit 10.

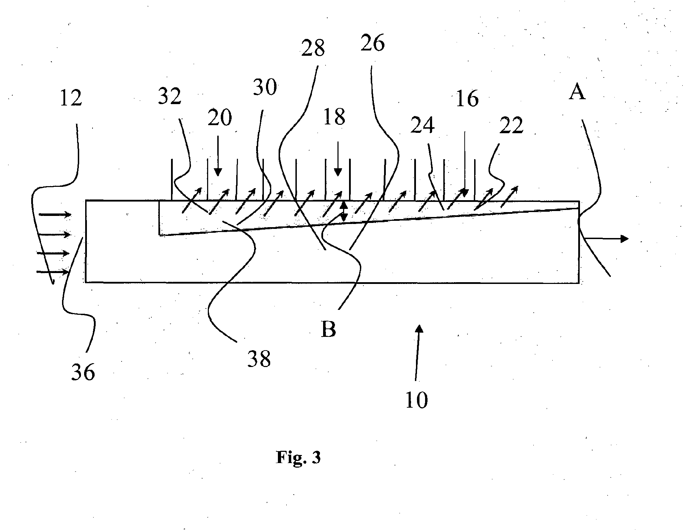

Fig. 3 shows a schematic cross-section of an air duct according to the first embodiment of the invention. The cross-section is taken along the longitudinal direction A of the active antenna system unit 10. The at least one fan 12, the at least one air duct inlet 36 and the air duct outlet 38 are schematically shown in the figure. As is shown in the figure, the air duct outlet 38 can be arranged to extend along one end of the majority of the cooling fins 22, 24, 26, 28, 30, 32 of each of the said heat sink units 16, 18, 20, and the gap size B of the air duct outlet 38 may further be arranged with varying dimensions, e.g. narrowing gap shape, along the extension of the air duct 14 in the longitudinal direction A of the active antenna system unit 10 in order to enable uniform outlet flow of air at the outlet 38 in order to enable substantially uniform cooling along all said cooling fins 22, 24, 26, 28, 30, 32.

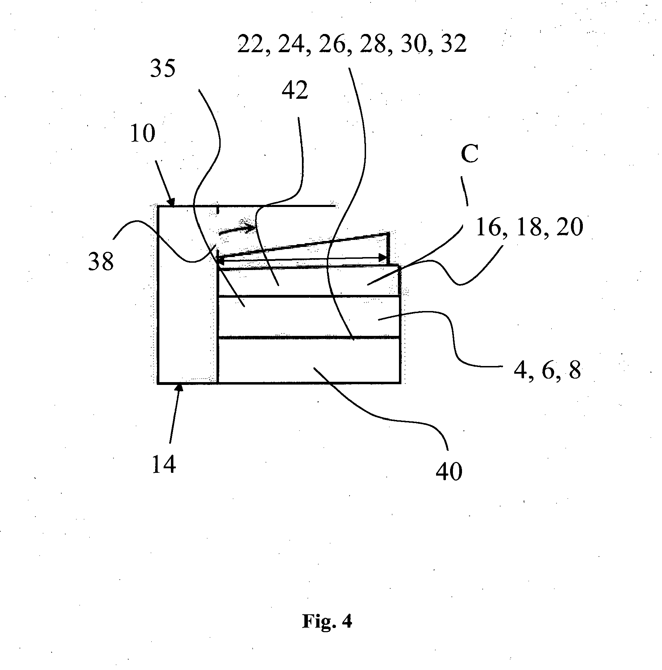

Fig. 4 shows another schematic cross-section of an air duct according to one embodiment of the invention. The cross-section is taken transversally to the extension of the air duct 14, i.e. at a right angle to the cross-section shown in figure 3. The air duct 14 and the air duct outlet 38 are shown in the figure. The direction of the secondary air flow 35 outside the outlet 38 is also indicated in the figure. In order to direct the secondary air flow outside the air duct outlet 38 towards the surface of the heat sink unit 16, 18, 20, a cover 42 can be arranged at the air duct 14 to direct the secondary air flow 35 over the cooling fins 22, 24, 26, 28, 30, 32. In order to enable air flow for natural cooling when the at least one fan is not in operation, the cover 42 preferably covers the heat sink units 16, 18, 20 only partly.

The design with the air duct 14 arranged along a longitudinal side of the active antenna system unit 10 does not affect the natural cooling when the at least one fan is shut off when forced cooling is not needed.

In the figure, the relative position of the cooling fins 22, 24, 26, 28, 30, 32, the at least one heat generating radio unit 4, 6, 8, and the at least one antenna 40 are schematically indicated.

As is shown in the figure, it is possible to arrange a cooling fin 22, 24, 26, 28, 30, 32 with varying dimensions, e.g. differing height, along the longitudinal extension C of the cooling fin 22, 24, 26, 28, 30, 32 in order to enable more uniform cooling of the at least one heat generating radio unit 4, 6, 8 along the length of said cooling fins 22, 24, 26, 28, 30, 32.

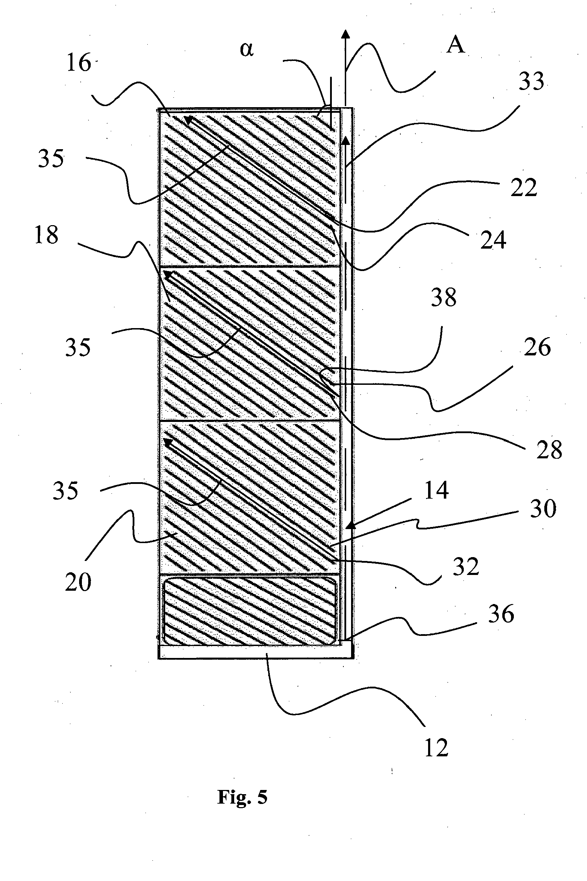

Fig. 5 shows a schematic view of a cooling system according to a second embodiment of the invention. The embodiment shown in figure 5 differs from the embodiment shown in figure 2 in that the at least one fan 12 is arranged outside the air duct 14 at one end of the air duct 14. The direction of flow 33, 35 of ambient air 34 is schematically shown in the figure.

According to this embodiment, the at least one fan 12 is arranged to generate a primary air flow 33 of ambient air 34 in the air duct 14 between at least one air duct inlet 36 and at least one air duct outlet 38 by introducing ambient air 34 into the air duct 14 from at least one air duct inlet 36 and where the air duct outlet 38 is arranged to direct a flow of ambient air 34 over a number of cooling fins 22, 24, 26, 28, 30, 32 of each of the said heat sink units 16, 18, 20, where the cooling fins 22, 24, 26, 28, 30, 32 are arranged oriented at an angle α with respect to the longitudinal direction A of the active antenna system unit 10.

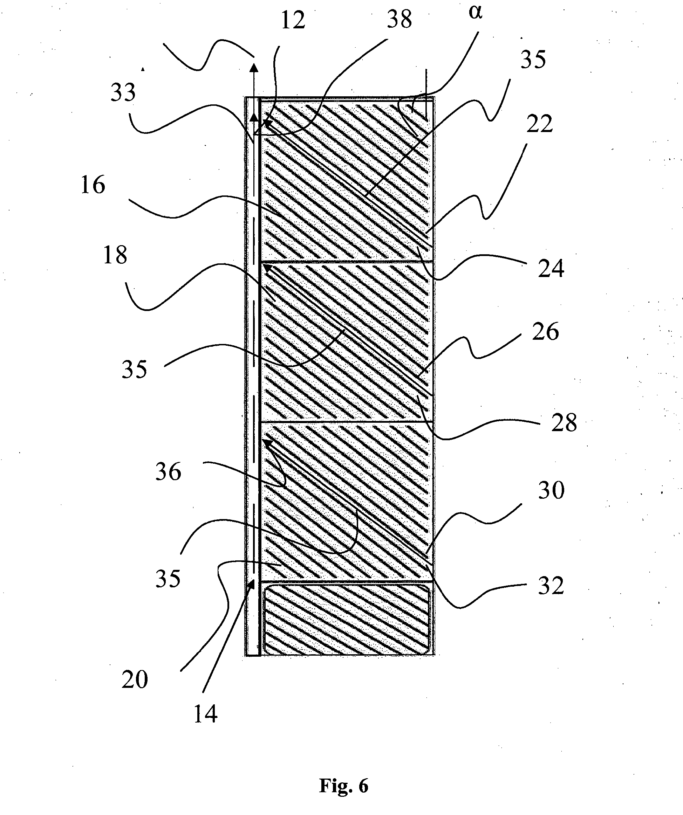

Fig. 6 shows a schematic view of a cooling system according to a third embodiment of the invention. The embodiment shown in figure 6 differs from the embodiment shown in figure 2 in that the air duct is arranged with its air duct inlet 36 along a longitudinal side of the active antenna system unit 10. The direction of flow 33, 35 of ambient air 34 is schematically shown in the figure.

According to this embodiment, the at least one fan 12 is arranged to generate a primary air flow 33 of ambient air 34 in the air duct 14 between at least one air duct inlet 36 and at least one air duct outlet 38 by introducing ambient air 34 into the air duct 14 from at least one air duct inlet 36 arranged along a longitudinal side of the active antenna system unit 10, and where the air duct inlet 36 is arranged to suck a secondary air flow 35 of ambient air 34 over a number of cooling fins 22, 24, 26, 28, 30, 32 of each of the said heat sink units 16, 18, 20, where the cooling fins 22, 24, 26, 28, 30, 32 are arranged oriented at an angle with respect to the longitudinal direction A of the active antenna system unit 10.

According to this embodiment, the air duct inlet 36 can be arranged to extend along one end of the majority of the cooling fins 22, 24, 26, 28, 30, 32 of each of the said heat sink units 16, 18, 20, and the gap size B of the air duct inlet 36 may further be arranged with varying dimensions, e.g. narrowing gap shape, along the extension of the air duct 14 in the longitudinal direction A of the active antenna system unit 10 in order to enable uniform inlet flow of air at the inlet 36 in order to enable substantially uniform cooling along all said cooling fins 22, 24, 26, 28, 30, 32.

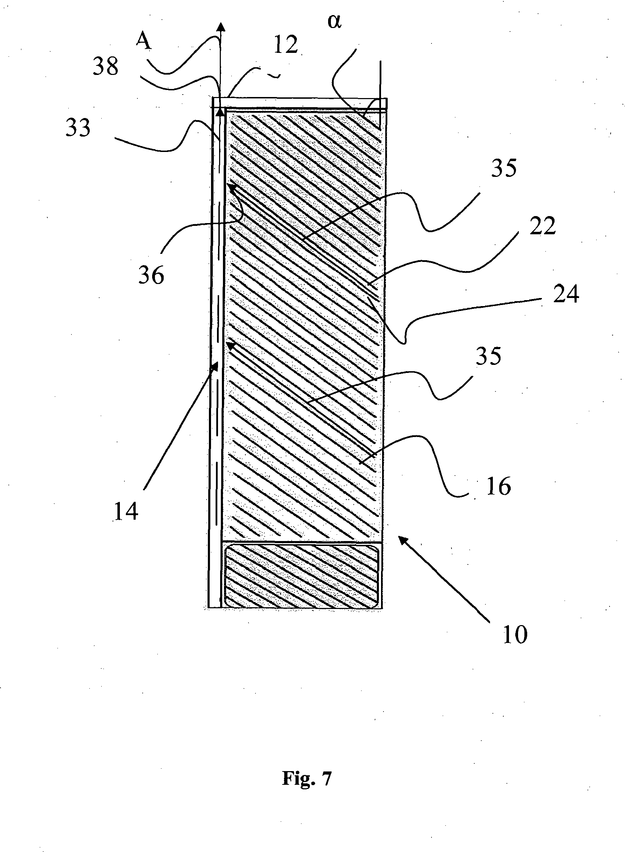

Fig. 7 shows a schematic view of a cooling system according to a fourth embodiment of the invention. The embodiment shown in figure 7 differs from the embodiment shown in figure 6 in that the at least one fan 12 is arranged outside the air duct 14 at one end of the air duct 14, and in that only one radio unit 4 with heat sink unit 16 is arranged in the active antenna system unit 10. The direction of flow 33, 35 of ambient air 34 is schematically shown in the figure.

According to this embodiment, the at least one fan 12 is arranged to generate a primary air flow 33 of ambient air 34 in the air duct 14 between at least one air duct inlet 36 and at least one air duct outlet 38 by introducing ambient air 34 into the air duct 14 from at least one air duct inlet 36 arranged along a longitudinal side of the active antenna system unit 10, and where the air duct inlet 36 is arranged to suck a secondary air flow 35 of ambient air 34 over a number of cooling fins 22, 24 of each of the said heat sink units 16 where the cooling fins 22, 24 are arranged oriented at an angle with respect to the longitudinal direction A of the active antenna system unit 10.

The invention also relates to a method for cooling at least one heat generating radio unit 4, 6, 8 in an active antenna system unit 10 using a cooling system 2, the cooling system 2 comprising at least one fan 12 and an air duct 14, comprising the steps of: connecting each heat generating radio unit 4, 6, 8 to be cooled by the cooling system 2 to a heat sink unit 16, 18, 20 comprising cooling fins 22, 24, 26, 28, 30, 32, arranging the heat sink unit 16, 18, 20 to transfer heat between the radio unit 4, 6, 8 and the ambient air 34, arranging the at least one fan 12 to generate a primary air flow 33 of ambient air 34 in the air duct 14 between at least one air duct inlet 36 and at least one air duct outlet 38, arranging the air duct 14 to extend in the longitudinal direction A of the active antenna system unit 10 along each of the said heat sink units 4, 6, 8 and to border on each of the said heat sink units 4, 6, 8, arranging the primary air flow 33 generated in the air duct 12 to flow substantially in the longitudinal direction A of the active antenna system unit 10 and further arranging the primary air flow 33 to generate a secondary air flow 35 of ambient air 34 over a number of cooling fins 22, 24, 26, 28, 30, 32 of each of the said heat sink units 4, 6, 8, and arranging the cooling fins 22, 24, 26, 28, 30, 32 to be cooled by the secondary air flow 35 to be oriented at an angle α with respect to the longitudinal direction A of the active antenna system unit 10.

The method for cooling a heat generating unit 4 can further comprise the step of arranging the at least one air duct outlet 38 to direct a flow of ambient air 34 over a number of cooling fins 22, 24, 26, 28, 30, 32 of each of the said heat sink units 16, 18, 20, or can further comprise the step of arranging the at least one air duct inlet 36 to suck a secondary air flow 35 of ambient air 34 over a number of cooling fins 22, 24, 26, 28, 30, 32 of each of the said heat sink units 16, 18, 20.

The invention has been described using straight cooling fins, but it is also possible to arrange the cooling fins with other shapes along their longitudinal extension such as e.g. to arrange a cooling fin wave formed or with curved shape along the longitudinal extension of the cooling fin. The angle α between a cooling fin and the longitudinal direction A of the active antenna system unit 10 can also be arranged to vary along the extension C of the cooling fin.

The present invention is not limited to the embodiments described above, but also relates to and incorporates all embodiments within the scope of the appended independent claims. Thus, it is possible to combine features from the embodiments described above as long as the combinations are possible.

## Claims

1. Cooling system (2) for cooling at least one heat generating radio unit (4, 6, 8) in an active antenna system unit (10), the cooling system (2) comprising at least one fan (12) and an air duct (14),
where each heat generating radio unit (4, 6, 8) to be cooled by the cooling system (2) is arranged connected to a heat sink unit (16, 18, 20) comprising cooling fins (22, 24, 26, 28, 30, 32), the heat sink unit (16, 18, 20) being arranged to transfer heat between the radio unit (4, 6, 8) and the ambient air (34),
where the at least one fan (12) is arranged to generate a primary air flow (33) of ambient air (34) in the air duct (14) between at least one air duct inlet (36) and at least one air duct outlet (38),
wherein the air duct (14) is arranged to extend in the longitudinal direction (A) of the active antenna system unit (10) along each of the said heat sink units (16, 18, 20) and to border on each of the said heat sink units (16, 18, 20), thus arranging the primary air flow (33) generated in the air duct (14) to flow substantially in the longitudinal direction (A) of the active antenna system unit (10),
where the cooling fins (22, 24, 26, 28, 30, 32) are arranged oriented at an angle being not zero degrees with respect to the longitudinal direction (A) of the active antenna system unit (10), wherein the at least one air duct outlet (38) is arranged to direct a air flow (35) of ambient air (34) over the number of cooling fins (22, 24, 26, 28, 30, 32), of each of said heat sink units (16, 18, 20), thus generating a secondary air flow (35) of ambient air (34) over the number of cooling fins (22, 24, 26, 28, 30, 32) of each of said heat sink units (16, 18, 20),
wherein the at least one air duct outlet (38) is arranged along a longitudinal side of the active antenna system unit (10),
wherein
a gap size (B) of the air duct outlet (38) is arranged with a narrowing gap size along the longitudinal direction (A) of the active antenna system unit (10).

2. Cooling system according to claim 1, wherein a cover (42) is arranged at the air duct (14) to direct the secondary air flow (35) over the cooling fins (22, 24, 26, 28, 30, 32).

3. Cooling system according to claim 1, wherein the angle (α) between a cooling fin (22, 24, 26, 28, 30, 32) and the longitudinal direction (A) of the active antenna system unit (10) is arranged to vary along the extension (C) of the cooling fin (22, 24, 26, 28, 30, 32).

4. Cooling system according to claim 1, wherein a cooling fin (22, 24, 26, 28, 30, 32) is arranged with varying dimensions along the longitudinal extension (C) of the cooling fin (22, 24, 26, 28, 30, 32).

5. Cooling system according to claim 1, wherein a cooling fin (22, 24, 26, 28, 30, 32) is arranged wave formed or with curved shape along the longitudinal extension (C) of the cooling fin (22, 24, 26, 28, 30, 32).

6. Cooling system according to claim 1, wherein the at least one fan (12) is a centrifugal fan.

7. Method for manufacturing a cooling system (2) for cooling at least one heat generating radio unit (4, 6, 8) in an active antenna system unit (10), the cooling system (2) comprising at least one fan (12) and an air duct (14), the method comprising the steps of: connecting each heat generating radio unit (4, 6, 8) to be cooled by the cooling system (2) to a heat sink unit (16, 18, 20) comprising cooling fins (22, 24, 26, 28, 30, 32), arranging the heat sink unit (16, 18, 20) to transfer heat between the radio unit (4, 6, 8) and the ambient air (34), arranging the at least one fan (12) to generate a primary air flow (33) of ambient air (34) in the air duct (14) between at least one air duct inlet (36) and at least one air duct outlet (38), arranging the air duct (14) to extend in a longitudinal direction (A) of the active antenna system unit (10) along each of the said heat sink units (4, 6, 8) and to border on each of the said heat sink units (4, 6, 8), thus arranging the primary air flow (33) generated in the air duct (14) to flow substantially in the longitudinal direction (A) of the active antenna system unit (10) and arranging the cooling fins (22, 24, 26, 28, 30, 32) to be oriented at an angle (α) being not zero degrees with respect to the longitudinal direction (A) of the active antenna system unit (10), further comprising the step of arranging the at least one air duct outlet (38) to direct a air flow (35) of ambient air (34) over the number of cooling fins (22, 24, 26, 28, 30, 32) of each of the said heat sink units (16, 18, 20), thus generating a secondary air flow (35) of ambient air (34) over the number of cooling fins (22, 24, 26, 28, 30, 32) of each of said heat sink units (16, 18, 20),
wherein the at least one air duct outlet (38) is arranged along a longitudinal side of the active antenna system unit (10), wherein
a gap size (B) of the air duct outlet (38) is arranged with a narrowing gap size along the longitudinal direction (A) of the active antenna system unit (10).

## Patentansprüche

1. Kühlsystem (2) zum Kühlen von mindestens einer wärmeerzeugenden Funkeinheit (4, 6, 8) in einer aktiven Antennensystemeinheit (10), wobei das Kühlsystem (2) mindestens ein Gebläse (12) und einen Luftkanal (14) umfasst,
wobei jede wärmeerzeugende Funkeinheit (4, 6, 8), die von dem Kühlsystem (2) gekühlt werden soll, mit einer Kühlkörpereinheit (16, 18, 20) verbunden angeordnet ist, die Kühlrippen (22, 24, 26, 28, 30, 32) umfasst, wobei die Kühlkörpereinheit (16, 18, 20) zum Übertragen von Wärme zwischen der Funkeinheit (4, 6, 8) und Umgebungsluft (34) angeordnet ist,
wobei das mindestens eine Gebläse (12) angeordnet ist, um einen Primärluftstrom (33) von Umgebungsluft (34) im Luftkanal (14) zwischen mindestens einem Luftkanaleingang (36) und mindestens einem Luftkanalausgang (38) zu erzeugen, wobei der Luftkanal (14) angeordnet ist, um sich in Längsrichtung (A) der aktiven Antennensystemeinheit (10) entlang jeder Kühlkörpereinheit (16, 18, 20) und angrenzend an jede Kühlkörpereinheit (16, 18, 20) zu erstrecken, wodurch der Primärluftstrom (33), der im Luftkanal (14) erzeugt wird, im Wesentlichen in Längsrichtung (A) der aktiven Antennensystemeinheit (10) strömt,
wobei die Kühlrippen (22, 24, 26, 28, 30, 32) mit einem Winkel ungleich null Grad mit Bezug auf die Längsrichtung (A) der aktiven Antennensystemeinheit (10) angeordnet sind, wobei der mindestens eine Luftkanalausgang (38) zum Leiten eines Luftstroms (35) von Umgebungsluft (34) über die mehreren Kühlrippen (22, 24, 26, 28, 30, 32) jeder Kühlkörpereinheit (16, 18, 20) angeordnet ist, wodurch ein sekundärer Luftstrom (35) von Umgebungsluft (34) über den mehreren Kühlrippen (22, 24, 26, 28, 30, 32) jeder Kühlkörpereinheit (16, 18, 20) erzeugt wird,
wobei der mindestens eine Luftkanalausgang (38) entlang einer Längsseite der aktiven Antennensystemeinheit (10) angeordnet ist,
wobei eine Spaltgröße (B) des Luftkanalausgangs (38) mit einer sich verengenden Spaltgröße entlang der Längsrichtung (A) der aktiven Antennensystemeinheit (10) angeordnet ist.

2. Kühlsystem nach Anspruch 1, wobei eine Abdeckung (42) am Luftkanal (14) angeordnet ist, um den sekundären Luftstrom (35) über die Kühlrippen (22, 24, 26, 28, 30, 32) zu lenken.

3. Kühlsystem nach Anspruch 1, wobei der Winkel (α) zwischen einer Kühlrippe (22, 24, 26, 28, 30, 32) und der Längsrichtung (A) der aktiven Antennensystemeinheit (10) zum Variieren entlang der Ausdehnung (C) der Kühlrippe (22, 24, 26, 28, 30, 32) angeordnet ist.

4. Kühlsystem nach Anspruch 1, wobei eine Kühlrippe (22, 24, 26, 28, 30, 32) mit unterschiedlichen Abmessungen entlang der Längsausdehnung (C) der Kühlrippe (22, 24, 26, 28, 30, 32) angeordnet ist.

5. Kühlsystem nach Anspruch 1, wobei eine Kühlrippe (22, 24, 26, 28, 30, 32) mit wellenförmiger oder gekrümmter Form entlang der Längsausdehnung (C) der Kühlrippe (22, 24, 26, 28, 30, 32) angeordnet ist.

6. Kühlsystem nach Anspruch 1, wobei das mindestens eine Gebläse (12) ein Zentrifugalgebläse ist.

7. Verfahren zum Herstellen eines Kühlsystems (2) zum Kühlen von mindestens einer wärmeerzeugenden Funkeinheit (4, 6, 8) in einer aktiven Antennensystemeinheit (10), wobei das Kühlsystem (2) mindestens ein Gebläse (12) und einen Luftkanal (14) umfasst, wobei das Verfahren die folgenden Schritte umfasst: Verbinden jeder wärmeerzeugenden Funkeinheit (4, 6, 8), die von dem Kühlsystem (2) gekühlt werden soll, mit einer Kühlkörpereinheit (16, 18, 20), umfassend Kühlrippen (22, 24, 26, 28, 30, 32), Anordnen der Kühlkörpereinheit (16, 18, 20) zum Übertragen von Wärme zwischen der Funkeinheit (4, 6, 8) und der Umgebungsluft (34), Anordnen des mindestens einen Gebläses (12) zum Erzeugen eines primären Luftstroms (33) aus Umgebungsluft (34) in dem Luftkanal (14) zwischen mindestens einem Luftkanaleingang (36) und mindestens einem Luftkanalausgang (38), Anordnen des Luftkanals (14), um sich in Längsrichtung (A) der aktiven Antennensystemeinheit (10) entlang jeder Kühlkörpereinheit (16, 18, 20) und angrenzend an jede Kühlkörpereinheit (16, 18, 20) zu erstrecken, wodurch der Primärluftstrom (33), der im Luftkanal (14) erzeugt wird, im Wesentlichen in Längsrichtung (A) der aktiven Antennensystemeinheit (10) strömt, und Anordnen der Kühlrippen (22, 24, 26, 28, 30, 32), um in einem Winkel (α) ungleich null Grad mit Bezug auf die Längsrichtung (A) der aktiven Antennensystemeinheit (10) ausgerichtet zu werden, ferner umfassend den Schritt des Anordnens des mindestens einen Luftkanalausgangs (38) zum Lenken eines Luftstroms (35) aus Umgebungsluft (34) über die mehreren Kühlrippen (22, 24, 26, 28, 30, 32) jeder Kühlkörpereinheit (16, 18, 20), wodurch ein Sekundärluftstrom (35) aus Umgebungsluft (34) über die mehreren Kühlrippen (22, 24, 26, 28, 30, 32) jeder Kühlkörpereinheit (16,18, 20) erzeugt wird,
wobei der mindestens eine Luftkanalausgang (38) entlang einer Längsseite der aktiven Antennensystemeinheit (10) angeordnet ist,
wobei eine Spaltgröße (B) des Luftkanalausgangs (38) mit einer sich verengenden Spaltgröße in Längsrichtung (A) der aktiven Antennensystemeinheit (10) angeordnet ist.

## Revendications

1. Système de refroidissement (2) pour refroidir au moins un bloc radio générant de la chaleur (4, 6, 8) dans une unité de système à antenne active (10), le système de refroidissement (2) comprenant au moins un ventilateur (12) et un conduit d'air (14), chaque bloc radio générant de la chaleur (4, 6, 8) devant être refroidi par le système de refroidissement (2) étant agencé de manière connectée à une unité de puits thermique (16, 18, 20) comprenant des ailettes de refroidissement (22, 24, 26, 28, 30, 32), l'unité de puits thermique (16, 18, 20) étant agencée pour transférer de la chaleur entre le bloc radio (4, 6, 8) et l'air ambiant (34),
l'au moins un ventilateur (12) étant agencé de manière à générer un flux d'air primaire (33) d'air ambiant (34) dans le conduit d'air (14) entre au moins une entrée de conduit d'air (36) et au moins une sortie de conduit d'air (38),
dans lequel le conduit d'air (14) est agencé de manière à s'étendre dans la direction longitudinale (A) de l'unité de système à antenne active (10) le long de chacune desdites unités de puits thermique (16, 18, 20) et de manière à être voisin de chacune desdites unités de puits thermique (16, 18, 20), agençant ainsi le flux d'air primaire (33) généré dans le conduit d'air (14) de manière à s'écouler sensiblement dans la direction longitudinale (A) de l'unité de système à antenne active (10),
les ailettes de refroidissement (22, 24, 26, 28, 30, 32) étant agencées de manière orientée suivant un angle différent de zéro degré par rapport à la direction longitudinale (A) de l'unité de système à antenne active (10), dans lequel l'au moins une sortie de conduit d'air (38) est agencée pour diriger un flux d'air (35) d'air ambiant (34) sur le certain nombre d'ailettes de refroidissement (22, 24, 26, 28, 30, 32) de chacune desdites unités de puits thermique (16, 18, 20), générant ainsi un flux d'air secondaire (35) d'air ambiant (34) sur le certain nombre d'ailettes de refroidissement (22, 24, 26, 28, 30, 32) de chacune desdites unités de puits thermique (16, 18, 20),
dans lequel l'au moins une sortie de conduit d'air (38) est agencée le long d'un côté longitudinal de l'unité de système à antenne active (10),
dans lequel une taille d'interstice (B) de la sortie de conduit d'air (38) est agencée avec une taille d'interstice se rétrécissant le long de la direction longitudinale (A) de l'unité de système à antenne active (10).

2. Système de refroidissement selon la revendication 1, dans lequel un couvercle (42) est agencé au niveau du conduit d'air (14) pour diriger le flux d'air secondaire (35) sur les ailettes de refroidissement (22, 24, 26, 28, 30, 32).

3. Système de refroidissement selon la revendication 1, dans lequel l'angle (α) entre une ailette de refroidissement (22, 24, 26, 28, 30, 32) et la direction longitudinale (A) de l'unité de système à antenne active (10) est agencé de manière à varier le long de l'étendue (C) de l'ailette de refroidissement (22, 24, 26, 28, 30, 32).

4. Système de refroidissement selon la revendication 1, dans lequel une ailette de refroidissement (22, 24, 26, 28, 30, 32) est agencée avec des dimensions variables le long de l'étendue longitudinale (C) de l'ailette de refroidissement (22, 24, 26, 28, 30, 32).

5. Système de refroidissement selon la revendication 1, dans lequel une ailette de refroidissement (22, 24, 26, 28, 30, 32) est agencée de manière ondulée ou avec une forme incurvée le long de l'étendue longitudinale (C) de l'ailette de refroidissement (22, 24, 26, 28, 30, 32).

6. Système de refroidissement selon la revendication 1, dans lequel l'au moins un ventilateur (12) est un ventilateur centrifuge.

7. Procédé de fabrication d'un système de refroidissement (2) pour refroidir au moins un bloc radio générant de la chaleur (4, 6, 8) dans une unité de système à antenne active (10), le système de refroidissement (2) comprenant au moins un ventilateur (12) et un conduit d'air (14), le procédé comprenant les étapes consistant à :
connecter chaque bloc radio générant de la chaleur (4, 6, 8) devant être refroidi par le système de refroidissement (2) à une unité de puits thermique (16, 18, 20) comprenant des ailettes de refroidissement (22, 24, 26, 28, 30, 32), agencer l'unité de puits thermique (16, 18, 20) pour transférer de la chaleur entre le bloc radio (4, 6, 8) et l'air ambiant (34), agencer l'au moins un ventilateur (12) de manière à générer un flux d'air primaire (33) d'air ambiant (34) dans le conduit d'air (14) entre au moins une entrée de conduit d'air (36) et au moins une sortie de conduit d'air (38), agencer le conduit d'air (14) de manière à s'étendre dans une direction longitudinale (A) de l'unité de système à antenne active (10) le long de chacune desdites unités de puits thermique (16, 18, 20) et de manière à être voisin de chacune desdites unités de puits thermique (16, 18, 20), agençant ainsi le flux d'air primaire (33) généré dans le conduit d'air (14) de manière à s'écouler sensiblement dans la direction longitudinale (A) de l'unité de système à antenne active (10), et agencer les ailettes de refroidissement (22, 24, 26, 28, 30, 32) de manière à être orientées suivant un angle (α) différent de zéro degré par rapport à la direction longitudinale (A) de l'unité de système à antenne active (10), comprenant en outre l'étape d'agencement de l'au moins une sortie de conduit d'air (38) pour diriger un flux d'air (35) d'air ambiant (34) sur le certain nombre d'ailettes de refroidissement (22, 24, 26, 28, 30, 32) de chacune desdites unités de puits thermique (16, 18, 20), générant ainsi un flux d'air secondaire (35) d'air ambiant (34) sur le certain nombre d'ailettes de refroidissement (22, 24, 26, 28, 30, 32) de chacune desdites unités de puits thermique (16, 18, 20), dans lequel l'au moins une sortie de conduit d'air (38) est agencée le long d'un côté longitudinal de l'unité de système à antenne active (10),
dans lequel une taille d'interstice (B) de la sortie de conduit d'air (38) est agencée avec une taille d'interstice se rétrécissant le long de la direction longitudinale (A) de l'unité de système à antenne active (10).
